**Europäisches Patentamt**

**European Patent Office**

**Office européen des brevets**

(11) Veröffentlichungsnummer: **0 088 923**

**A2**

(12) **EUROPÄISCHE PATENTANMELDUNG**

(21) Anmeldenummer: **83101902.1**

(22) Anmeldetag: **26.02.83**

(51) Int. Cl.³: **H 01 L 23/04**
**H 01 L 21/56**

(30) Priorität: **13.03.82 DE 3209174**

(43) Veröffentlichungstag der Anmeldung:
**21.09.83 Patentblatt 83/38**

(84) Benannte Vertragsstaaten:
**FR GB IT NL**

(71) Anmelder: **BROWN, BOVERI & CIE Aktiengesellschaft**
**Kallstadter Strasse 1**
**D-6800 Mannheim 31(DE)**

(72) Erfinder: **Eisele, Dieter, Dipl.-Phys.**
**Edisonstrasse 10**
**D-6840 Lampertheim(DE)**

(72) Erfinder: **Weimann, Klaus, Dipl.-Phys.**
**Wierdenstrasse 19**
**D-6840 Lampertheim(DE)**

(74) Vertreter: **Kempe, Wolfgang, Dr. et al,**
**c/o Brown, Boveri & Cie AG Postfach 351**
**D-6800 Mannheim 1(DE)**

(54) **Sandwich für druckkontaktierbare Halbleiter-Leistungsbauelemente und Verfahren zu seiner Herstellung.**

(57) Der Sandwich für druckkontaktierbare Halbleiter-Leistungsbauelemente besteht aus einem scheibenförmigen Halbleiterelement (5), je einer napfförmigen, duktilen Elektrode (3,4) und je einer Hartmetall-Scheibe (1,2), die unverlierbar in die Elektroden (3,4) eingepreßt ist. Die Elektroden (3,4) besitzen eine Krempe (6), deren Außendurchmesser gleich dem Außendurchmesser des Halbleiterelementes (5) ist. Der Zwischenraum zwischen den Krempen (6) und dem Halbleiterelement (5) ist mit Passivierungsmasse (7) ausgegossen und verklebt.

Fig. 2

EP 0 088 923 A2

BROWN, BOVERI & CIE   AKTIENGESELLSCHAFT
Mannheim                              11. März 1982
Mp.-Nr. 516/82                       ZPT/P3-Bi/Bt

Sandwich für druckkontaktierbare Halbleiter-Leistungsbauelemente und Verfahren zu seiner Herstellung.

Die Erfindung betrifft einen Sandwich für druckkontaktierbare Halbleiter-Leistungsbauelemente, bestehend aus
einem scheibenförmigen Halbleiterelement, je einer napfförmigen, duktilen Elektrode auf jeder Hauptoberfläche
des Halbleiterelements und je einer Hartmetall-Scheibe
in dem Napf der duktilen Elektroden, wobei die Elektroden mittels Kunststoff am Halbleiterelement fixiert
sind, sowie ein Verfahren zur Herstellung eines solchen
Sandwich.

Ein derartiger Sandwich ist bekannt aus der DE-PS
20 39 806. Dabei werden die napfförmigen Elektroden mit
Hilfe einer mechanischen Zentriervorrichtung auf den
Hauptoberflächen der Halbleiterscheibe justiert. Durch
das Auftragen eines haftfesten und elastischen Kunststoffes werden die justierten Elektroden an der Halbleiterscheibe befestigt.

Das Justieren und anschließende Verkleben der Einzelteile des Halbleiterbauelementes sind wichtige Schritte bei der Herstellung, da davon die Lebensdauer des Halbleiterbauelementes, insbesondere bei starken Last- und Temperaturwechselbeanspruchungen, entscheidend beeinflußt wird. Andererseits handelt es sich dabei um Verfahrensschritte, die praktisch nicht automatisierbar sind und deshalb die Herstellung verlangsamen und verteuern.

Der vorliegenden Erfindung liegt die Aufgabe zugrunde, ein Sandwich für druckkontaktierbare Halbleiter-Leistungsbauelemente der eingangs beschriebenen Art anzugeben, welches wesentlich einfacher und schneller herzustellen und als selbständige Einheit handhabbar oder handelsfähig ist.

Diese Aufgabe wird dadurch gelöst, daß die Elektroden eine Krempe besitzen, daß der Außendurchmesser der Krempe gleich dem Außendurchmesser des Halbleiterelementes ist und daß der Zwischenraum zwischen den Krempen und dem Halbleiterelement mit Passivierungsmasse ausgegossen ist.

Durch die Ausbildung der Elektroden mit einer Krempe, deren Außendurchmesser gleich dem Außendurchmesser der Halbleiterelemente ist, lassen sich die Einzelteile des Sandwich in einer einfachen Vorrichtung justieren. Weiterhin verhindern die Krempen, daß beim Ausgießen der Zwischenräume Passivierungsmasse auf die Oberseite der Elektroden gelangt. Nach dem Erstarren der Passivierungsmasse sind die Elektroden und das Halbleiterelement mechanisch stabil miteinander befestigt, so daß der Sandwich selbständig handhabbar ist; außerdem ist der Rand des Halbleiterelementes passiviert, so daß auf die Verwendung von vorpassivierten Halbleiterelementen, wie es in der obengenannten Patentschrift beschrieben ist, verzichtet werden kann.

Gemäß einer vorteilhaften Weiterbildung sind die Hartmetallscheiben unverlierbar in die Elektroden eingepreßt. Dies kann bei der Herstellung der Elektroden geschehen, indem die Hartmetallscheiben in einer Presse mit Scheiben aus duktilem Metall in einer entsprechenden Form zusammengepreßt werden. Dabei wird das duktile Metall in einer Art Tiefziehverfahren über die jeweils zugehörige Hartmetall-Scheibe gezogen. Auf diese Weise werden Toleranzprobleme umgangen und die Hartmetall-Scheiben bleiben unverlierbar im Napf der Elektroden.

Vorzugsweise sind die Krempen leicht nach außen gebogen. Auf diese Weise dichten die Krempen zweier nebeneinanderliegender Sandwiches die Außenseite der Elektroden besonders gut gegeneinander ab, wodurch das Ausgießen mit Passivierungsmasse erleichtert wird. Nach dem Aushärten der Masse lassen sich die einzelnen Sandwiches leicht voneinander trennen.

Die Elektroden selbst bestehen aus Silber oder vorzugsweise aus versilberten Kupferblechen.

Ein besonders einfaches Verfahren zum Herstellen der erfindungsgemäßen Sandwiches besteht darin, daß Elektroden und Halbleiterelemente abwechselnd gestapelt werden, daß der Stapel zusammengepreßt wird und daß die Zwischenräume zwischen den Krempen und den Halbleiterelementen gemeinsam ausgegossen werden. Auf diese Weise lassen sich in einem einzigen Arbeitsgang eine Vielzahl von Sandwiches gleichzeitig fertigstellen, ohne daß die Gefahr besteht, daß Passivierungsmasse an Stellen gerät, wo sie unerwünscht ist. Außerdem kann durch die Verwendung von Passivierungsmasse als Vergußmasse auf die Verwendung von vorpassivierten Halbleiterelementen verzichtet werden; Verkleben und Passivieren geschehen in einem einzigen Arbeitsgang.

Anhand der Zeichnung soll die Erfindung in Form eines Ausführungsbeispiels näher erläutert werden.

Es zeigen:
Fig. 1    die Einzelteile eines Halbleiter-Sandwiches als Explosionsbild und
Fig. 2    einen Stapel von fertigvergossenen Sandwiches.

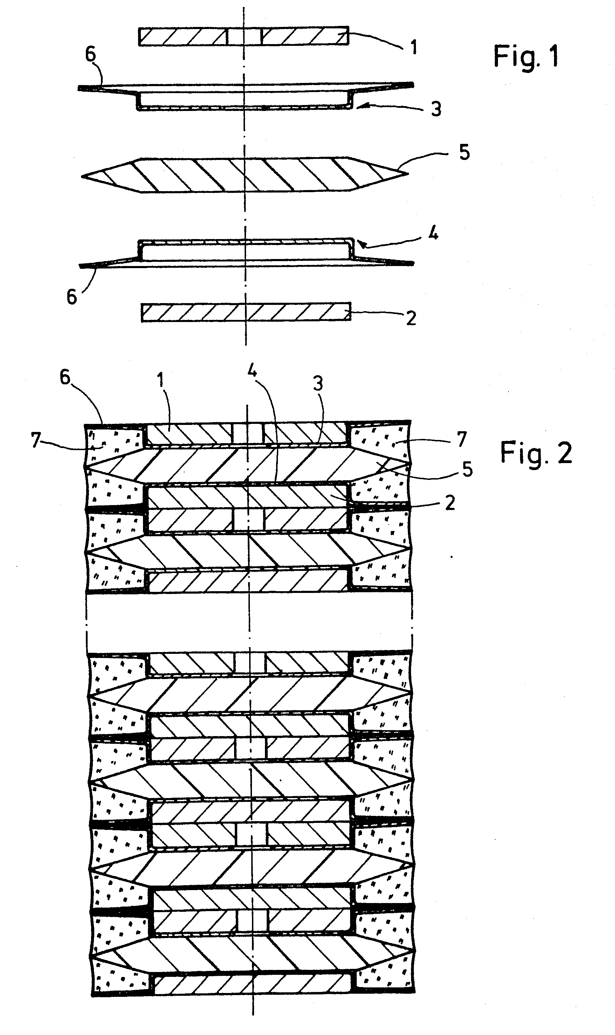

In Fig. 1 erkennt man eine Scheibe 1 aus Hartmetall, insbesondere aus Molybdän, mit einer zentralen Öffnung zur Durchführung eines Steuerelektrodenanschlusses. Man erkennt ferner eine erste napfförmige, duktile Elektrode 3 mit einer leicht nach außen gebogenen Krempe 6. Auch die erste Elektrode 3 besitzt eine zentrale Öffnung zur Durchführung eines Steuerelektrodenanschlusses. Erste Elektrode 3 und erste Hartmetall-Scheibe 1 befinden sich auf der einen Hauptoberfläche eines Halbleiterelementes 5. Auf der zweiten Hauptoberfläche des Halbleiterelementes 5 sind eine gleichartige Elektrode 4 mit Krempe 6 und eine weitere Hartmetall-Scheibe 2 angeordnet.

Fig. 2 zeigt einen Stapel von fertiggestellten Sandwiches. Die Hartmetallscheiben 1,2 sind in die napfförmigen Elektroden 3,4 unverlierbar eingepreßt. Der Außendurchmesser der Krempen 6 und der Außendurchmesser des Halbleiterelementes 5 sind gleich, so daß die justierende Montage besonders einfach durchgeführt werden kann. Die Zwischenräume zwischen den Krempen 6 und den Halbleiterelementen 5 sind mit einer Passivierungsmasse 7 ausgegossen. Als Passivierungsmasse eignet sich insbesondere Silikonkautschuk. Vor dem Ausgießen der Hohlräume mit Passivierungsmasse 7 wird der Stapel von Hartmetallscheiben 1,2, Elektroden 3,4 und Halbleiterelementen 5 zusammengepreßt, so daß die Rücken an Rücken
aneinanderliegenden Krempen 6 die Oberseite der Elektroden und der Hartmetall-Scheiben gegen das Eindringen von
Passivierungsmasse 7 abdichten. Nach dem Aushärten der
Passivierungsmasse 7 lassen sich die einzelnen Sandwiches leicht voneinander trennen und bilden individuell
handhabbare und handelsfähige Einheiten.

Ansprüche

1. Sandwich für druckkontaktierbare Halbleiter-Leistungsbauelemente, bestehend aus einem scheibenförmigen Halbleiterelement (5), je einer napfförmigen, duktilen Elektrode (3,4) auf jeder Hauptoberfläche des Halbleiterelementes (5) und je einer Hartmetall-Scheibe (1,2) in dem Napf der duktilen Elektroden (3,4), wobei die Elektroden (3,4) mittels Kunststoff (7) am Halbleiterelement (5) fixiert sind, dadurch gekennzeichnet, daß die Elektroden (3,4) eine Krempe (6) besitzen, daß der Außendurchmesser der Krempe (6) gleich dem Außendurchmesser des Halbleiterelementes (5) ist und daß der Zwischenraum zwischen den Krempen (6) und dem Halbleiterelement (5) mit Passivierungsmasse (7) ausgegossen ist.

2. Sandwich nach Anspruch 1, dadurch gekennzeichnet, daß die Hartmetallscheiben (1,2) unverlierbar in die Elektroden (3,4) eingepreßt sind.

3. Sandwich nach Anspruch 1 oder 2, dadurch gekennzeichnet, daß die Krempen (6) leicht nach außen gebogen sind.

4. Sandwich nach Anspruch 1,2 oder 3, dadurch gekennzeichnet, daß die Elektroden (3,4) aus Silberblech, aus versilbertem Kupferblech oder mit Silber plattiertem Kupferblech bestehen.

5. Verfahren zum Herstellen eines Sandwich nach den Ansprüchen 1 bis 4, dadurch gekennzeichnet, daß Elektroden und Halbleiterelemente (5) abwechselnd gestapelt

516/82 7 0088923

werden, daß der Stapel zusammengepreßt wird und daß die Zwischenräume zwischen den Krempen (6) und den Halbleiterelementen (5) gemeinsam ausgegossen werden.

0088923

Fig. 1

Fig. 2